# EUROPEAN PATENT APPLICATION

(11) **EP 2 477 225 A2**
(43) Date of publication of application: **18.07.2012**
(21) Application number: 12150862.6
(22) Date of filing: 12.01.2012
(51) Int. Cl.: H01L 25/075

(54) **Adhesive film for light emitting device and method of manufacturing LED package using the same**

(30) Priority: 14.01.2011 KR 20110004162
(71) Applicant: Samsung LED Co., Ltd., Yongin-City, Gyeonggi-Do (KR)
(72) Inventor: Park, Na Na, Seoul (KR); Park, Il Woo, Gyeonggi-do (KR); Lee, Kyu Jin, Gyeonggi-do (KR)
(74) Representative: Grünecker, Kinkeldey, Stockmair & Schwanhäusser

(57) **Abstract**

Provided is an adhesive film for an LED chip, including: a double-sided adhesive layer (40) having the LED chip (50) adhered to an upper surface thereof and a lead frame adhered to a lower surface thereof; an ultraviolet (UV) cured layer (30) adhered to one surface of the double-sided adhesive layer (40); and upper and lower cover layers (10,20) respectively adhered to faces exposed to the exterior of the double-sided adhesive layer and the UV cured layer.

## Description

### CROSS-REFERENCE TO RELATED APPLICATIONS

This application claims the priority of Korean Patent Application No. 10-2011-0004162 filed on January 14, 2011, in the Korean Intellectual Property Office, the disclosure of which is incorporated herein by reference.

### BACKGROUND OF THE INVENTION

### Field of the Invention

The present invention relates to an adhesive film for a light emitting device and a method of manufacturing a light emitting diode (LED) package using the same, and more particularly, to an adhesive film for a light emitting device, for substantially decreasing light loss in light emitted from a light emitting device during a junction procedure with an electrode and a method of manufacturing an LED package using the same.

### Description of the Related Art

A light emitting diode (LED), a kind of a semiconductor light source, is a semiconductor device capable of emitting light having various colors through the recombination of electrons and electron holes in a junction portion between p-type and n-type semiconductors when current is applied thereto.

Since the LED has a prolonged lifespan, low power consumption, excellent initial driving characteristics, high vibration-resistance, and other positive characteristics, as compared to a light source using a filament, the demand for LEDs has continuously increased.

In particular, a group III nitride semiconductor LED capable of emitting blue light of a short wavelenth region has been much in demand.

In the case of a light emitting module used for a liquid crystal display (LCD) backlight unit, a cold cathode fluorescent lamp (CCFL) according to the related art has been used, but since the CCFL operates using a mercury gas, this may lead to an environmental pollution. Furthermore, the CCFL operates at a low-speed response time, has low color reproducibility, and is not suitable for use with a lightweight, slim and compact LCD panel.

As compared to the CCFL according to the related art, an LED is environmentally-friendly and able to operate at a high-speed response time of several nanoseconds so as to be effective for a video signal stream, and is also able to be impulsive driven.

In addition, the LED has 100% color reproducibility and is able to not only adjust a quantity of light emitted by red, green and blue LEDs to optionally change brightness, color temperature, or the like, but may also be suitable for use with a lightweight, slim and compact LCD panel. A current trend, therefore, is to actively employ the LED as a light emitting module for a backlight unit.

According to the related art, in order to adhere an LED as the above-mentioned light emitting device to an upper part of an electrode such as a lead frame, a resin is dotted on the lead frame, and the LED is then pressed and adhered thereto.

For example, after coating an upper part of the lead frame with an agitator bonding resin by using a device such as a stepping pin, an LED chip is adhered thereto.

However, the above-described LED adhering method according to the related art may frequently cause a tailing effect or a dripping effect, or the like, depending upon bonding resin properties, and the amount of dotting of a bonding resin in single-products is not constant at the time of manufacturing an LED package.

Furthermore, at the time of manufacturing the LED package, in general, a die bonding process is performed, and a thermosetting process is then fulfilled. Since in the thermosetting process, resin uniformity may become different on respective portions of the LED according to a distribution level of heat transferred to the resin dotted on the lead frame, a volume change on the dotted portions of the LED may be generated to partially reduce brightness of the LED.

In order to use the LED package as a blue light emitting module or the like, a substantially arrayed form of LED packages may be manufactured. At this time, a plurality of LED chips should be die-bonded to a substrate, but this method may cause working efficiency to be significantly decreased.

### SUMMARY OF INVENTION

An aspect of the present invention provides an adhesive film for a light emitting device and a method of manufacturing an LED package using the same, in which the light emitting device is adhered to an electrode to maintain resin uniformity, thereby significantly reducing light loss while maintaining a relatively maximum brightness value.

Another aspect of the present invention provides a method of manufacturing an LED package, which is able to improve working efficiency through a shortened process procedure in which, when the array form of LED packages are manufactured, a plurality of LED chips are simply adhered to an upper part of a substrate without a die bonding process.

According to an aspect of the present invention, there is provided an adhesive film for a light emitting device, the adhesive film including: a double-sided adhesive layer having the light emitting device adhered to an upper surface thereof and an electrode adhered to a lower surface thereof; an ultraviolet (UV) cured layer adhered to one surface of the double-sided adhesive layer; and upper and lower cover layers respectively adhered to faces exposed to the exterior of the double-sided adhesive layer and the UV cured layer.

The double-sided adhesive layer may be formed of a silicon-containing thermosetting resin, or one of rubber-based, acrylate-based, silicon-based, epoxy-based and vinyl-based materials, or a mixture thereof, or a high permeability mineral-based material.

The double-sided adhesive layer may further include one of a metal, a ceramic and a carbon nanotube.

The double-sided adhesive layer may further include conductive particles.

The double-sided adhesive layer may further include high radiation filler.

The double-sided adhesive layer may be formed to include a plurality of unit adhesive layers cut to have a size corresponding to that of the light emitting device.

The double-sided adhesive layer may be provided with a position guide part formed on a boundary part of a light emitting device adhesion surface to guide an LED to an adhesion position of the light emitting device on the upper surface of the double-sided adhesive layer.

Here, the position guide part may be one of a groove part formed in the upper surface of the double-sided adhesive layer, a protrusion part formed on the upper surface of the double-sided adhesive layer, and a mark on the upper surface of the double-sided adhesive layer.

Acording to another aspect of the present invention, there is provided a method of manufacturing an LED package, the method including: preparing an adhesive film by sequentailly stacking a lower cover layer, a UV cured layer, an adhesive layer and an upper cover layer; removing the upper cover layer of the adhesive film; adhering at least one LED chip on an exposed upper surface of the adhesive layer of the adhesive film; UV hardening the adhesive film provided with the LED chip adhered thereto; eliminating the UV cured layer and the lower cover layer of the UV-cured adhesive film; arranging a package body having an electrode exposed to a chip mounting region; and adhering a lower surface of the exposed adhesive layer of the adhesive film to the electrode exposed to the chip mounting region.

Here, the LED chip may be adhered to an upper part of the electrode in a flip-chip manner.

The electrode may be one pair of lead frames disposed to be partially exposed to the chip mounting region of the package body, and the lower surface of the exposed adhesive layer of the adhesive film may be adhered to an exposed region of one of the lead frames.

AUV hardening temperature may range from 160°C to 180°C.

The method of manufacturing an LED package may further include adhering a plurality of LED chips to the exposed upper surface of the adhesive layer so as to be spaced apart from one another after the removing of the upper cover layer, and then, cutting the adhesive film into respective LED chips.

The method of manufacturing an LED package may further include adhering a wafer to the exposed upper surface of the adhesive layer after the removing of the upper cover layer, cutting the adhesive film into a plurality of unit adhesive films to have a size corresponding to that of the LED chip, and then, manufacturing the LED chip by using the wafer of the unit adhesive film.

The preparing of the adhesive film may be performed to include first cutting the adhesive layer into respective LED chips and then stacking the cut adhesive layers on the UV cured layer to be spaced apart from one another thereon.

The preparing of the adhesive film may further include forming a position guide part on a boundary part of an adhesion surface of the LED chip in order to guide an LED to an adhesion position of the LED chip on the stacked adhesive layer, after stacking the adhesive layer on the UV cured layer.

According to another aspect of the present invention, there is provided a method of manufacturing an LED package, the method including: preparing an adhesive film by sequentailly stacking a lower cover layer, a UV cured layer, an adhesive layer and an upper cover layer; removing the upper cover layer of the adhesive film; adhering a wafer to an exposed upper surface of the adhesive layer of the adhesive film; cutting the adhesive film provided with the wafer adhered thereto into a plurality of unit adhesive films to have a size corresponding to that of the LED chip; manufacturing the respective LED chips by using the wafer of the unit adhesive film; UV hardening the adhesive film manufactured as the respective LED chips; eliminating the UV cured layer and the lower cover layer of the UV-cured adhesive film; arranging a package body having an electrode exposed to a chip mounting region; and adhering a lower surface of the exposed adhesive layer of the adhesive film to the electrode exposed to the chip mounting region.

### BRIEF DESCRIPTION OF THE DRAWINGS

The above and other aspects, features and other advantages of the present invention will be more clearly understood from the following detailed description taken in conjunction with the accompanying drawings, in which:
FIG. 1 is a side view of an adhesive film according to an embodiment of the present invention;
FIG. 2 is a side view of the adhesive film of FIG. 1 from which an upper cover layer has been removed;
FIG. 3 is a side view of the adhesive film of FIG. 2 with a light emitting device adhered to an upper surface of an adhesive layer thereof;
FIG. 4 is a side view of the adhesive film of FIG. 3 cut in respective light emitting devices;
FIG. 5 is a side view of a combined light emitting device and electrode adhered to each other using the adhesive film according to the embodiment of the present invention;
FIG. 6 is a side view of an adhesive film according to another embodiment of the present invention;
FIG. 7 is a side view showing an example of a position guide part provided in an adhesive layer of an adhesive film according to an embodiment of the present invention;
FIG. 8 is a side view showing another example of a position guide part provided in an adhesive layer of an adhesive film according to an embodiment of the present invention; and
FIG. 9 is a side view of an adhesive film according to another embodiment of the present invention.

### DETAILED DESCRIPTION OF THE INVENTION

Embodiments of the present invention will now be described in detail with reference to the accompanying drawings such that they could be easily practiced by those having skill in the art to which the present invention pertains. However, in describing the embodiments of the present invention, detailed descriptions of well-known functions or constructions will be omitted so as not to obscure the description of the present invention with unnecessary detail.

In addition, like reference numerals denote like elements throughout the drawings.

Unless explicitly described to the contrary, the word "comprise" and variations such as "comprises" or "comprising," will be understood to imply the inclusion of stated elements but not the exclusion of other elements.

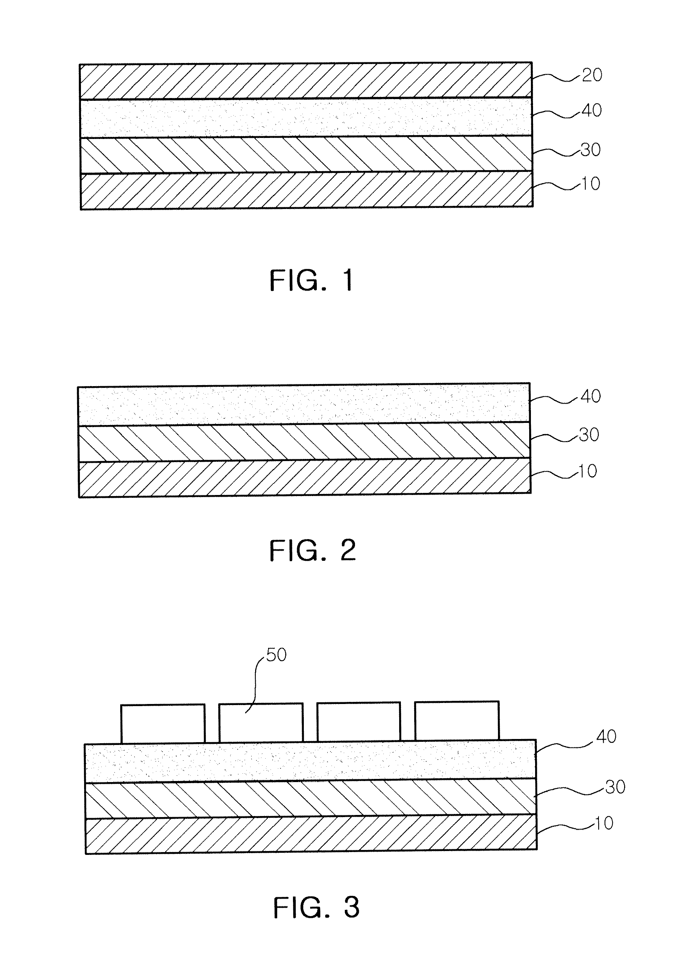

Referring to FIGS. 1 to 5, an adhesive film for a light emitting device according to an embodiment of the present invention may include an adhesive layer 40 having adhesive strength formed on both sides thereof to adhere a light emitting device to an upper surface thereof and an electrode 60 to a lower surface thereof, a UV cured layer adhered to the lower surface of the adhesive layer 40, and upper and lower cover layers 20 and 10 respectively adhered to an upper surface of the adhesive layer 40 and a lower surface of the UV cured layer 30.

Here, the light emitting device may be a photoelectric device emitting light when an electrical signal is applied thereto, and in this case, various photoelectric devices may be applicable, for example, a light emitting diode (LED) chip 50 may be applied according to an embodiment of the present invention. In the present embodiment, the LED chip 50 will be described as an example.

The electrode 60 may be formed to be partially exposed to the exterior of the package body to be used as a terminal through which an external electrical signal is applied when the LED package is mounted on a substrate. The electrode 60 may be formed of a metallic material having excellent heat conductivity, for example, Au, Ag, Cu, or the like, which is capable of increasing electrical conductivity and smoothly radiating heat.

In the case of a structure according to the present embodiment, the LED chip 50 may be mounted on the electrode 60 in a flip-chip bonding manner without a conductive wire, but this connection manner may be different according to the type of chip used, and the invention is not particularly limited thereto.

For example, the electrode may be configured of one pair of lead frames which are disposed to be partially exposed on a chip mounting region of the package body. Here, a lower surface of an exposed adhesive layer in the adhesive film to which the LED chip is adhered may be adhered to an upper surface of an exposed region in one of the lead frames so as to be directly electrically connected thereto. The LED chip may be configured to be connected to a lead frame disposed at an opposite position, through a conductive wire.

Moreover, the conductive wire is provided as an example of a wiring structure, but may be properly substituted with a different form of wiring structure in which an electrical signal transfer function can be carried out, for example, a metal line, or the like.

The adhesive layer 40 may be formed to be maintained to have a minimal thickness in order to significantly increase light efficiency in light emitted from the LED chip 50, and may be formed to have a thickness of 50uM or less.

In order to significantly increase the light efficiency in light emitted from the LED chip 5, the film should be transparent to enhance refraction and light transmittance, that is, the adhesive layer 40 may be formed of a material having relatively high refraction and excellent light transmittance, for example, a silicon-containing thermosetting resin, or one of a rubber-based material, an acrylate-based material, a silicon-based material, an epoxy-based material and a vinyl-based material, or a mixture thereof, and may be also formed of a high permeability mineral-based material in some cases.

In addition, in the case of the adhesive layer 40, a high heat conduction material, for example, a metal, a ceramic, and a carbon nanotube, or the like, may be added thereto in order to ensure smooth heat radiation.

In the case of a flip-chip type LED package according to the present embodiment, conductive particles may be added to serve as an electrical path between the LED chip 50 and the electrode and thus improve electrical connection performance.

In a case in which the LED package is used for a high power product to which a high-level current is applied, a relatively-high heat may flow not only to the LED package but also to the adhesive film connected thereto. Since the above-described thermosetting resin, or one of rubber-based, acrylate-based, silicon-based, silicon-based, epoxy-basedand vinyl-based materials, or a mixture thereof, or a mineral-based material, or the like, has deteriorated heat characteristics in high temperature environment; filler of Al₂O₃, B₂O₃, or the like having excellent radiation characteristics may be added to the adhesive layer 40.

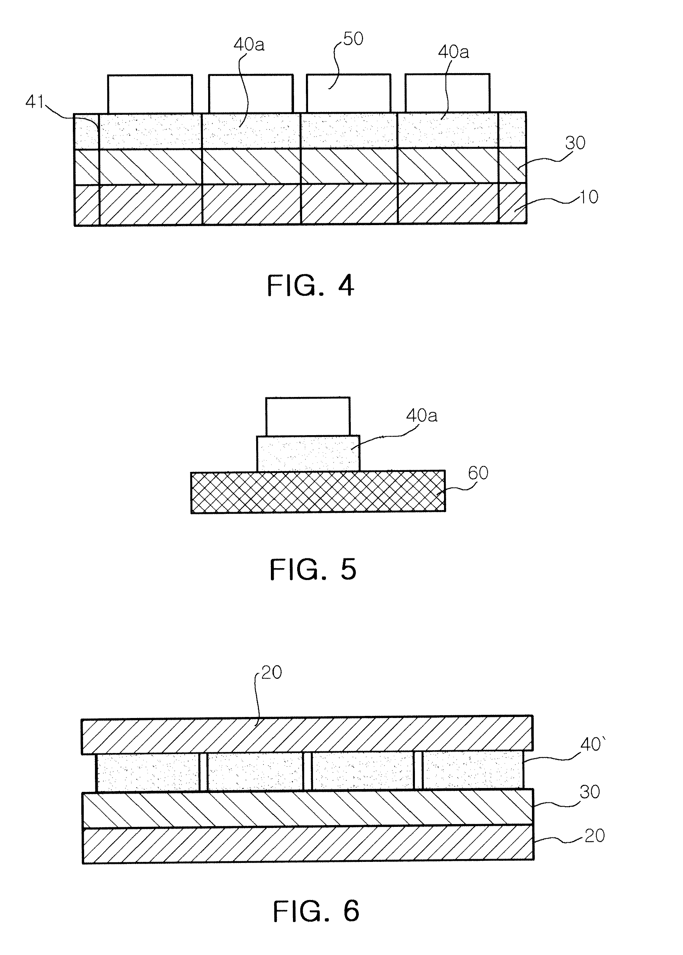

Meanwhile, after the LED chip 50 is adhered to the adhesive film, the adhesive film may be cut perpendicularly to correspond to a size of the LED chip 50 at the time of manufacturing single products. In some cases, the adhesive layer may be first configured of a plurality of cut unit adhesive layers 40' in compliance with the number of the LED chips 50, and then, on both sides thereof, the UV cured layer 30 and the upper cover layer 20 may be configured to be adhered thereto, as shown in FIG. 6.

On an upper surface of the adhesive layer 40, a position guide part may be formed on a position thereof corresponding to a boundary part of an adhesion surface of the LED chip 50, to guide an LED to an adhesion position of the LED chip 50.

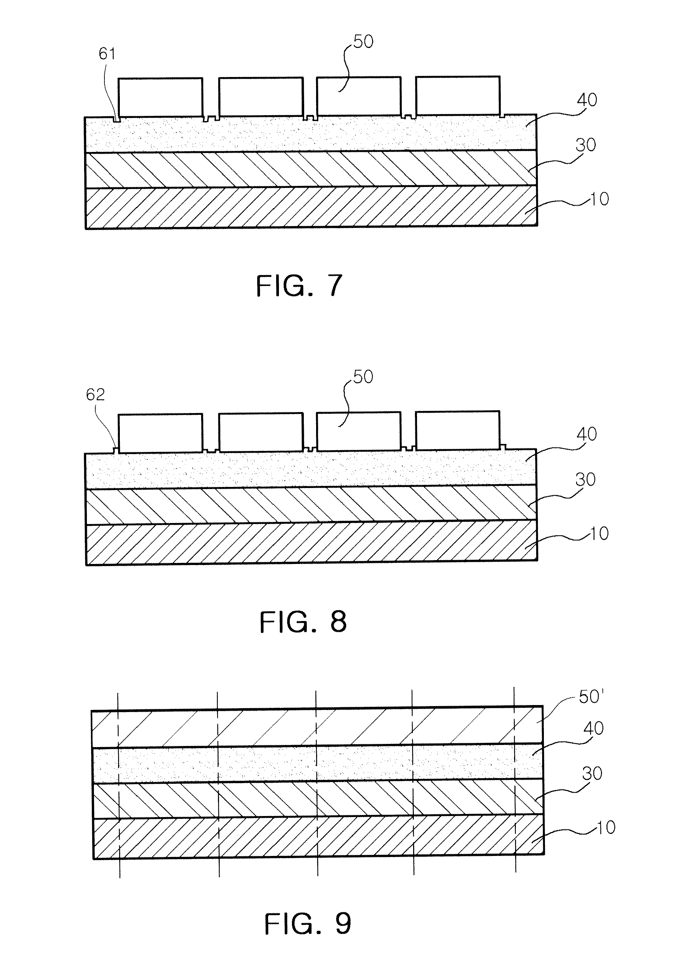

The position guide part may be formed as a groove part 61 formed to be downwardly recessed in an upper surface of the adhesive layer 40 shown in FIG. 7, or as a protrusion part 62 formed to upwardly protrude from the upper surface of the adhesive layer 40 shown in FIG. 8. Besides, a simple mark, able to be identified by the naked eye of a worker, or the like, may be variously formed.

The upper and lower cover layers 20 and 10 may be formed of a material having excellent heat resistance properties capable of enduring a die-bonding UV hardening temperature of 160∼180°C, or 170°C or more. Here, the upper cover layer 20 may prevent a scratch occurring on the upper surface of the adhesive layer 40 to which the LED chip 50 is adhered, may protect the adhesive layer from a foreign substance, and may be removed when the LED chip 50 is adhered thereto. The lower cover layer 10 may be provided to protect a lower surface of the adhesive layer 40 to which the electrode 60 is adhered, and may be removed at the time of being adhered to the electrode 60.

The UV cured layer 30 may be formed to prevent an occurrence of a defect in which the lower cover layer 10 is stuck fast to the lower surface of the adhesive layer 40 so as not to be easily detached therefrom in the case of not using the UV cured layer 30. That is, at the time of UV hardening, the UV cured layer 30 may be separated from the lower surface of the adhesive layer 40, together with the lower cover layer 10. The UV cured layer 30 may be manufactured in a thermosetting scheme such that it does not react during die bonding, but may be manufactured in other schemes without being limited thereto.

A method of manufacturing an LED package according to an embodiment of the present invention, using the adhesive film configured as described above, will be described.

First, an adhesive film including the lower cover layer 10, the UV cured layer 30, the adhesive layer 40 and the upper cover layer 20 stacked in sequence, may be prepared.

In preparing the adhesive film, a position guide part 61 or 62 may be formed on the upper surface of the adhesive layer 40 stacked on the UV cured layer 30, that is, formed on a position thereof corresponding to an adhesion surface boundary part of the LED chip 50, so as to guide the LED to an adhesion position of the LED chip 50 such that a worker may confirm the adhesion position of the LED chip 50 to progress the working.

The position guide part 61 or 62 may be formed to be downwardly recessed or upwardly protrude, and may be also formed through other various schemes, for example, printing a simple mark able to be identified by a naked eye of a worker, or the like.

Subsequently, the upper cover layer 20 may be removed from the adhesive film, and the LED chips 50 may be adhered to the upper surface of the exposed adhesive layer 40 of the adhesive film. In the present embodiment is described a plurality of LED chips 50 adhered in the flip-chip manner to the adhesive layer 40 to be spaced apart from one another thereon, but the kind, the form or the number of these light emitting devices is not limited thereto.

For example, referring to FIG. 9, a wafer 50', which becomes a material of the LED chip, may be adhered to an upper surface of the adhesive layer 40, and the adhesive film may be cut along a virtual cutting line to have a size corresponding to that of the LED chip to thus produce unit adhesive films, and then, the wafers 50' of the unit adhesive films may be manufactured as respective LED chips.

Meanwhile, according to the present embodiment, the LED package may be manufactured in a bar-like shaped array form, but in the case of producing a single product package to which only each one of the LED chips 50 is adhered, additional operations in which the adhesive film is cut along cutting lines 41 with regard to respective LED chips, may be performed.

In addition, in the adhesive film manufacturing operation, the adhesive layer may be first cut into unit adhesive layers 40' to have an arrangement including an interval between the package and the LED chip 50, and the unit adhesive layers 40' may be adhered to an upper part of the UV cured layer 30 to be spaced apart from one another, and thereon, the upper cover layer 20 may be adhered to then manufacture the adhesive film. At this time, when the UV cured layer 30 and the lower cover layer 10 are unnecessary for the single product package, the above-described cutting operation on the adhesive film may be omitted.

Further, at the time of manufacturing the unit adhesive layers 40', the adhesive layer may be cut together such that the UV cured layer 30 and the lower cover layer 10 are adhered to lower surfaces of the respective unit adhesive layers 40'.

Then, the adhesive film having the LED chip 50 adhered thereto may be UV cured at a temperature of 160∼180°C or 170°C or more, and subsequently, the lower cover layer 10 and the UV cured layer 30 may be sequentially removed.

UV hardening is to harden a liquid adhesive agent into a cured solid state by using ultraviolet rays. In the case of ultraviolet hardening, strong ultraviolet light energy generated from an ultraviolet lamp is provided to a light initiator as energy initiating a chemical reaction between elements such that a monomer and an oligomer, principal ingredients of ultraviolet-hardening paint, are momentarily changed into polymers. At this time, the monomer and the oligomer are liquid in a normal state of 1 atmospheric pressure and 25°C, but when the liquid becomes polymer, the monomer and the oligomer are changed into a solid state.

The UV hardening process may be performed without a diluent or a solvent, thereby reducing environmental pollution factors and particularly providing several excellent physical properties after the hardening, generally rare in the thermosetting resin or printing, for example, improved polishing, abrasion resistance, surface hardening and adhesion strength after the hardening, or the like.

Next, a package body in which the electrode is formed to be exposed to the chip mounting region may be prepared, and the lower surface of the adhesive layer 40 may be adhered to the upper part of the electrode exposed to the chip mounting region, to thus manufacture the LED package.

Here, in the case of the LED chip 50, the adhesive layer 40 may be directly adhered to the upper part of the electrode 60 in a flip-chip bonding manner without using a conductive wire. In a case in which the electrode is configured of one pair of lead frames, a lower surface of the exposed adhesive layer of the adhesive film may be adhered to be directly electrically connected to an upper part of an exposed region in one of the lead frames, and the LED chip may be configured to be connected to an opposite lead frame through a conductive wire.

In the present embodiment, in a case in which the adhesive film is provided in a roll form in an elongated direction and the manufacturing process is not for a single product, the plurality of LED chips 50 may be disposed in line along an elongated direction of the adhesive film on the adhesive film, such that the present embodiment may be applicable to a backlight unit of a television set, a lighting device, a whole length of a desk lamp, a lighting device for a mobile phone, or the like, thereby simplifying manufacturing and assembling processes of components while heightening an added value.

As set forth above, in an adhesive film for a light emitting device according to an embodiment of the present invention, a plurality of light emitting devices may be installed on an electrode to maintain resin uniformity, thereby significantly reducing light loss in light emitted from the light emitting device due to a nonuniform die bonding according to adhesion portions of the light emitting device or respective light emitting devices according to the related art, while obtaining an enhanced brightness value.

In particular, a method of manufacturing an LED package using the adhesive film for a light emitting device according to the embodiment of the present invention may be relatively more useful for a case in which an LED chip is adhered in a wafer state or a case of manufacturing the package in a flip-chip manner by directly electrically connecting the LED chip to the electrode without a wire.

Furthermore, when manufacturing an array form of LED packages, respective LED chips may be adhered to the adhesive film formed in a rolled form at a time without a die bonding process and then the adhesive film may be cut according to the need to thus manufacture the package as a single product, thereby simplifying a working process and improving workability.

While the present invention has been shown and described in connection with the embodiments in the, it will be apparent to those skilled in the art that modifications and variations can be made without departing from the spirit and scope of the invention as defined by the appended claims.

## Claims

1. An adhesive film for a light emitting device, comprising:
a double-sided adhesive layer having the light emitting device adhered to an upper surface thereof and an electrode adhered to a lower surface thereof;
an ultraviolet (UV) cured layer adhered to one surface of the double-sided adhesive layer; and
upper and lower cover layers respectively adhered to faces exposed to the exterior of the double-sided adhesive layer and the UV cured layer.

2. The adhesive film of claim 1, wherein the double-sided adhesive layer is formed of a silicon-containing thermosetting resin, or one of rubber-based, acrylate-based, silicon-based, epoxy-based and vinyl-based materials, or a mixture thereof, or a high light permeability of mineral-based material.

3. The adhesive film of claim 1, wherein the double-sided adhesive layer further includes one of a metal, a ceramic and a carbon nanotube.

4. The adhesive film of claim 1, wherein the double-sided adhesive layer further includes conductive particles.

5. The adhesive film of claim 1, wherein the double-sided adhesive layer is formed to include a plurality of unit adhesive layers cut to have a size corresponding to that of the light emitting device.

6. The adhesive film of claim 1, wherein the double-sided adhesive layer is provided with a position guide part formed on a boundary part of a light emitting device adhesion surface to guide an LED to an adhesion position of the light emitting device on the upper surface of the double-sided adhesive layer.

7. The adhesive film of claim 6, wherein the position guide part is at least one of a groove part and a protrusion part formed in the upper surface of the double-sided adhesive layer.

8. A method of manufacturing an LED package, the method comprising:
preparing an adhesive film by sequentailly stacking a lower cover layer, a UV cured layer, an adhesive layer and an upper cover layer;
removing the upper cover layer of the adhesive film;
adhering at least one LED chip on an exposed upper surface of the adhesive layer of the adhesive film;
UV hardening the adhesive film provided with the LED chip adhered thereto;
eliminating the UV cured layer and the lower cover layer of the UV-cured adhesive film;
arranging a package body having an electrode exposed to a chip mounting region; and
adhering a lower surface of the exposed adhesive layer of the adhesive film to the electrode exposed to the chip mounting region.

9. The method of claim 8, wherein the LED chip is adhered to an upper part of the electrode in a flip-chip manner.

10. The method of claim 8, further comprising adhering a plurality of LED chips to the exposed upper surface of the adhesive layer so as to be spaced apart from one another after the removing of the upper cover layer, and then, cutting the adhesive film into respective LED chips.

11. The method of claim 8, wherein the preparing of the adhesive film includes first cutting the adhesive layer into respective LED chips and then stacking the cut adhesive layers on the UV cured layer to be spaced apart from one another thereon.

12. The method of claim 8, wherein the preparing of the adhesive film further includes forming a position guide part on a boundary part of an adhesion surface of the LED chip in order to guide an LED to an adhesion position of the LED chip on the stacked adhesive layer, after stacking the adhesive layer on the UV cured layer.

13. The method of claim 12, wherein the forming of the position guide part includes forming at least one of a groove part formed to be inwardly recessed from the upper surface of the adhesive layer, and a protrusion part formed to protrude upwardly from the upper surface of the adhesive layer.

14. A method of manufacturing an LED package, the method comprising:
preparing an adhesive film by sequentailly stacking a lower cover layer, a UV cured layer, an adhesive layer and an upper cover layer;
removing the upper cover layer of the adhesive film;
adhering a wafer to an exposed upper surface of the adhesive layer of the adhesive film;
cutting the adhesive film provided with the wafer adhered thereto into a plurality of unit adhesive films to have a size corresponding to that of the LED chip;
manufacturing the respective LED chips by using the wafer of the unit adhesive film;
UV hardening the adhesive film manufactured as the respective LED chips;
eliminating the UV cured layer and the lower cover layer of the UV-cured adhesive film;
arranging a package body having an electrode exposed to a chip mounting region; and
adhering a lower surface of the exposed adhesive layer of the adhesive film to the electrode exposed to the chip mounting region.

15. The method of claim 14, wherein the electrode is one pair of lead frames disposed to be partially exposed to the chip mounting region of the package body, and the lower surface of the exposed adhesive layer of the adhesive film is adhered to an exposed region of one of the lead frames.
